# EUROPÄISCHE PATENTSCHRIFT

(11) **EP 1 217 731 B1**
(45) Veröffentlichungstag und Bekanntmachung des Hinweises auf die Patenterteilung: **07.04.2010**
(21) Anmeldenummer: 01000708.6
(22) Anmeldetag: 05.12.2001
(51) Int. Cl.: H03G 7/00

(54) **Schaltungsanordnung**
Electric circuit
Circuit électrique

(30) Priorität: 06.12.2000 DE 10060483
(43) Veröffentlichungstag der Anmeldung: 26.06.2002
(73) Patentinhaber: NXP B.V., 5656 AG Eindhoven (NL)
(72) Erfinder: Kohsiek, Cord Heinrich, Weisshausstrasse 2 52066, Aachen (DE)
(74) Vertreter: Schouten, Marcus Maria

(56) Entgegenhaltungen:
- EP-A1- 0 331 234
- JP-A- 62 018 843
- JP-A- 62 213 329
- JP-A- 63 215 120

## Beschreibung

Die Erfindung betrifft eine Schaltungsanordnung sowie ein Verfahren zum Erzeugen und Verstärken eines in seiner Amplitude begrenzten Gleichspannungssignals, dessen Pegelspannung im wesentlichen proportional zum Logarithmus der Spannungsamplitude eines Eingengssignals ist; allgemeiner bezieht sich die vorliegende Erfindung auf das Gebiet der analogen integrierten Schaltungen.

Derartige Schaltungsanordnungen sowie derartige Verfahren erfüllen eine zweifache Funktion: Zum einen dienen sie der Verstärkung eines Wechselspannungssignals, das der Schaltungsanordnung über deren Eingangsanschlüsse zugeführt wird; gleichzeitig wird durch eine derartige Schaltungsanordnung sowie durch ein derartiges Verfahren die Amplitude des Ausgangssignals begrenzt. Demzufolge ist für eine derartige Schaltungsanordnung auch der Begriff "Begrenzerverstärker" geläufig; solche Begrenzerverstärker kommen beispielsweise bei der frequenzmodulierten ZF-Verstärkung in Radioempfängern oder auch bei der Trägergewinnung aus amplitudenmodulierten Signalen zum Einsatz

Wird nun bei einem derartigen Begrenzerverstärker eine einfache Erweiterung, beispielsweise in Form einer Gleichrichterstufe, vorgenommen, so läßt sich eine Gleichspannung erzeugen, die in weiten Bereichen proportional zum Logarithmus der Amplitude der Spannung des Eingangssignals ist; trägt man mithin die Amplitude des Ausgangssignals gegen den Logarithmus der Amplitude der Eingangsspannung auf, so ergibt sich über weite Bereiche der Eingangsspannung eine Gerade mit im wesentlichen konstanter Steigung; diese Gerade wird gemeinhin als "Pegelkennlinie" bezeichnet.

In bezug auf derartige Schaltungsanordnungen sowie auf derartige Verfahren zum Erzeugen und Verstärken eines in seiner Amplitude begrenzten Gleichspannungssignals ist nun zu berücksichtigen, dass die Pegelspannung des Gleichspannungssignals bei frequenzmoduliertem Eingangssignal (sogenanntem "FM-moduliertem Eingangssignal") dann verfälscht wird, wenn das Eingangssignal zuvor eine Schaltung mit frequenzabhängigem Amplitudengang, beispielsweise in Form eines Zwischenfrequenzfilters, durchlaufen hat. In einer solchen Schaltung erfolgt eine Umwandlung von Frequenzmodulation (FM) in Amplitudenmodulation (AM), die sich dann in der Pegelspannung des Gleichspannungssignals unweigerlich als unerwünschte Pegelschwankung auswirkt, obwohl das Eingangssignal im Grunde genommen lediglich frequenzmoduliert (FM) war.

JP 63 215120 A zeigt einen Interferenzendetektor mit dem Interferenzen so genau wie möglich ermittelt werden sollen, die durch Schwankungen einer Arbeitsspannung entstehen. Der Interferenzendetektor enthält eine logarithmische Ermittlungsschaltung, die ermittelt, ob ein Empfangssignal einer logarithmischen Form entspricht, eine Ermittlungsschaltung für Gleichspannungspegel, die beim Demodulieren eines Signals mit einem bestimmten Frequenzmodulationsfaktor entstehen und eine Schaltung, in der die schwankende Arbeitspannung gemäß dem Gleichspannungspegel der Ermittlungsschaltung angepasst wird.

EP 0 331 234 A1 zeigt einen linearen Verstärker und Demodulator für amplituden- oder frequenzmodulierte Signale für einen logarithmischen Verstärker mit einer Anzahl von Verstärkerstufen. Der Verstärker enthält eine Antilogarithmierschaltung und eine Gleichspannungsabtrennung zwischen dem logarithmischen Verstärker und der Antilogarithmierschaltung.

Ausgehend von den vorstehend dargelegten Nachteilen und Unzulänglichkeiten liegt der vorliegenden Erfindung die Aufgabe zugrunde, eine Schaltungsanordnung sowie ein Verfahren der eingangs genannten Art zur Verfügung zu stellen, durch die die Pegelanzeige, das heisst die Pegelspannung des in der Schaltungsanordnung sowie mittels des Verfahrens erzeugten und verstärkten Gleichspannungssignals nur von der Amplitude, nicht jedoch von der Frequenz des Eingangssignals abhängt.

Diese Aufgabe wird durch eine Schaltungsanordnung mit den im Anspruch 1 angegebenen Merkmalen sowie durch ein Verfahren mit den im Anspruch 17 angegebenen Merkmalen gelöst. Vorteilhafte Ausgestaltungen und zweckmässige Weiterbildungen der vorliegenden Erfindung sind in den jeweiligen Unteransprüchen gekennzeichnet. Gemäss der Lehre der vorliegenden Erfindung erfolgt mithin eine Korrektur des Pegelsignals mittels eines aus der Frequenz-(FM-)Demodulatoreinheit gewonnenen Korrektursignals dergestalt, dass der Einfluss des frequenzabhängigen Amplitudengangs auf das Pegelsignal kompensiert wird; dies bedeutet mit anderen Worten, dass das durch die vorliegende Erfindung erzeugte und verstärkte, in seiner Amplitude begrenzte Gleichspannungssignal, dessen Pegelspannung im wesentlichen proportional zum Logarithmus der Spannungsamplitude eines Eingangssignals ist, nur noch Informationen über die Amplitude, nicht jedoch über die Frequenz enthält.

Der Fachmann wird in diesem Zusammenhang mithin insbesondere zu schätzen wissen, dass durch die vorliegende Erfindung eine korrigierende Kompensation des Einflusses der Frequenzmodulation auf die (logarithmische) Pegelanzeigespannung erfolgt; eine derartige Kompensation wird dadurch erforderlich, dass frequenzmodulierte Signale nach Durchlaufen einer Filterstufe zuvor nicht vorhandene Amplitudenschwankungen aufweisen, denn die Filterstufe hat eine frequenzabhängige Durchlaßdämpfung. Durch die vorliegende Erfindung ist es auf für den Fachmann überraschende Weise möglich, dass die Aussagen der Pegelspannung über den Signalpegel erheblich genauer werden, so dass sich völlig neue Anwendungen für die Schaltungsanordnung erschließen.

Der Kern der vorliegenden Erfindung ist darin zu sehen, dass zunächst die Pegelinformation des Eingangssignals mittels der mindestens einen Verstärkerschaltung mit den mindestens zwei Verstärkungsstufen angezeigt und/oder erfaßt wird. Nachdem das Ausgangssignal der letzten Verstärkungsstufe, insbesondere der Kollektorschaltungen der letzten Verstärkungsstufe, mittels der mindestens einen Frequenz-(FM-)Demodulatoreinheit frequenzdemoduliert ist, erfolgt in der mindestens einen Quadriererstufe ein Korrigieren des Ausgangssignals der Frequenz-(FM-)Demodulatoreinheit, insbesondere des Wechselspannungsanteils des Ausgangssignals der Frequenz-(FM-)Demodulatoreinheit. Schließlich wird in mindestens einer Stromaddierereinheit die Pegelspannung des Ausgangssignals der Quadriererstufe mit der Pegelspannung der Verstärkungsstufen addiert.

Gemäß einer bevorzugten Ausgestaltungsform der vorliegenden Erfindung wird die Quadrierestufe durch mindestens eine insbesondere nicht-gegengekoppelte Differenzverstärkerstufe, durch mindestens eine der Differenzverstärkerstufe zugeordnete Zwischenstufe sowie durch mindestens eine nachgeschaltete Multipliziererstufe zum Multiplizieren des Ausgangssignals der Zwischenstufe gebildet. Dieses Multiplikationsprodukt wird in der mindestens einen Stromaddierereinheit zu den Pegelkennlinienanteilen der Verstärkungsstufen addiert.

In diesem Zusammenhang kann die Pegelspannung des Ausgangssignals der Quadriererstufe jeweils an verschiedene der Verstärkerschaltung vorgeschaltete Schaltungen mit frequenzabhängigem Amplitudengang, beispielsweise an Zwischenfrequenzfilter mit jeweils verschieden gekrümmten Filterdurchlaßkurven, angepaßt werden, indem die Verstärkung der Quadriererstufe variiert wird.

Die Differenzverstärkerstufe ist zweckmäßigerweise an den Ausgang der Frequenzdemodulatorstufe geschaltet; prinzipiell handelt es sich in diesem Zusammenhang bei einem Differenzverstärker um einen linear verstärkenden Gleichspannungsverstärker, dessen Ausgangsspannung zur Differenz der beiden Eingangsspannungen proportional ist; die Grundschaltung weist zwei am Emitteranschluß zusammengeschaltete Transistoren auf, die aus einer gemeinsamen Konstantstromquelle gespeist werden; der Differenzverstärker ist im Regelfall symmetrisch aufgebaut, weil sich dann Temperatureinflüsse und Nichtlinearitäten weitestgehend kompensieren, woraus ein geringes Offsetverhalten resultiert.

In bezug auf die vorliegende Erfindung ist zu berücksichtigen, dass zwar aus dem Stand der Technik eine Möglichkeit bekannt ist, den Fehler in einer Frequenz-(FM-)Demodulatoreinheit, der durch die Gruppenlaufzeit eines vor der Frequenz-(FM-)Demodulatoreinheit angeordneten Filters verursacht wird, zu kompensieren (vgl. Druckschrift JP 61-187402); ferner ist im Stand der Technik neben verschiedenen Typen von Frequenz-(FM-) Demodulatoreinheiten (vgl. etwa die Druckschriften DE-OS 17 66 837, JP-A-04-207209, JP-A-11-055038, JP-A-57-015505 oder auch JP-A-60-070804) auch das Filtern des Ausgangssignals eines Begrenzerverstärkers vor einer Frequenz-(FM-) Demodulatoreinheit zum Vermeiden von Verzerrungen offenbart (vgl. JP-A-55-083347).

Allerdings behandelt keines der vorgenannten Dokumente aus dem Stand der Technik die Frage der Erfassung nicht nur der Amplitude, sondern - infolge der frequenzabhängigen Transfercharakteristik - auch der Frequenz des Eingangssignals; dies bedeutet mit anderen Worten, dass die Dokumente aus dem Stand der Technik keinerlei Anregungen in bezug auf die Reduzierung des unerwünschten Einflusses des frequenzabhängigen Amplitudengangs liefern.

Die Erfindung betrifft schließlich auch eine integrierte Schaltung, insbesondere eine analoge integrierte Schaltung, aufweisend mindestens eine Schaltungsanordnung der vorstehend beschriebenen Art und/oder arbeitend gemäß einem Verfahren der vorstehend beschriebenen Art.

Ein Ausführungsbeispiel der vorliegenden Erfindung wird nachstehend anhand der Zeichnungen näher erläutert.
Es zeigt:
Fig. 1 ein Ausführungsbeispiel einer Schaltungsanordnung gemäß der vorliegenden Erfindung, in schematischer Prinzipdarstellung;
Fig. 2 ein Diagramm, in dem die Momentanfrequenz eines Zwischenfrequenzsignals gegen die Zeit Z aufgetragen ist;
Fig. 3 ein Diagramm, in dem die in bezug auf die Amplitude gewölbte Durchlaßkennlinie eines integrierten Filters gegen die Frequenz F aufgetragen ist;
Fig 4 ein Diagramm, in dem die von der im integrierten Filter (vgl. Fig. 3) entstehenden Pegelschwankung überlagerte Pegelspannung oder "Pegelinformation" gegen die Zeit Z aufgetragen ist;
Fig. 5 ein Diagramm, in dem der Wechselspannungsanteil des Ausgangssignals der Frequenz-(FM-)Demodulatoreinheit gegen die Zeit aufgetragen ist;
Fig 6 ein Diagramm, in dem der in der Korrekturschaltung quadrierte Wechselspannungsanteil des Ausgangssignals der Frequenz-(FM-)Demodulatoreinheit (vgl. Fig. 5) gegen die Zeit aufgetragen ist; und
Fig. 7 ein Diagramm, in dem die korrigierte Pegelspannung, das heißt das zum Pegelsignal der Verstärkerschaltung addierte Korrektursignal der Quadriererstufe gegen die Zeit aufgetragen ist.

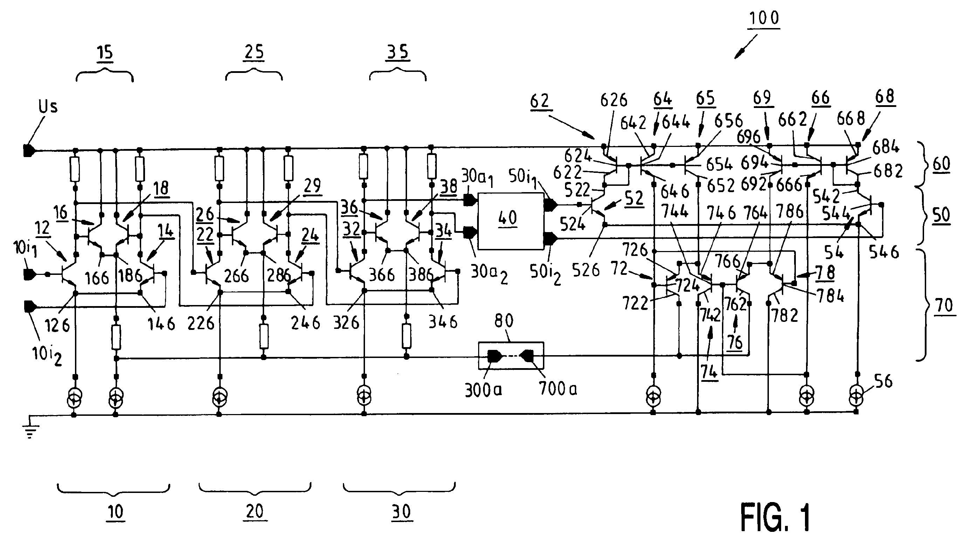

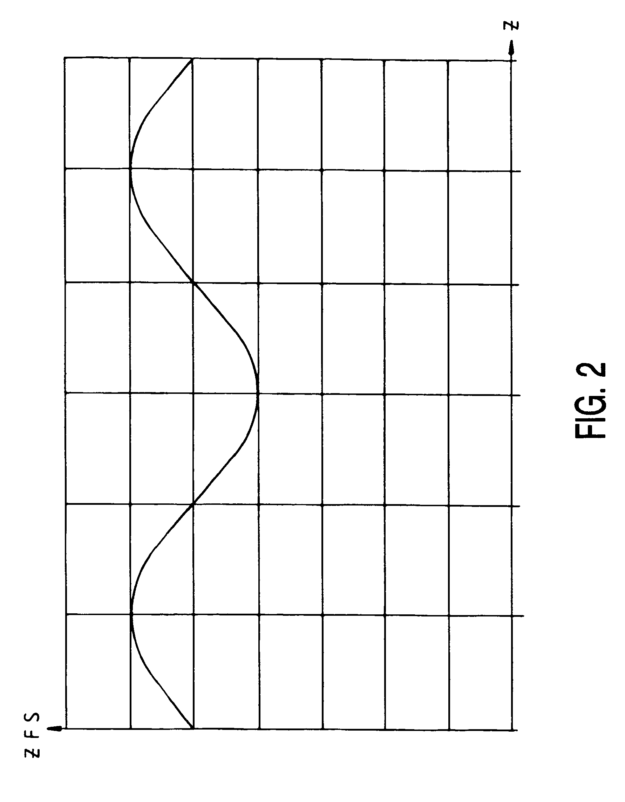

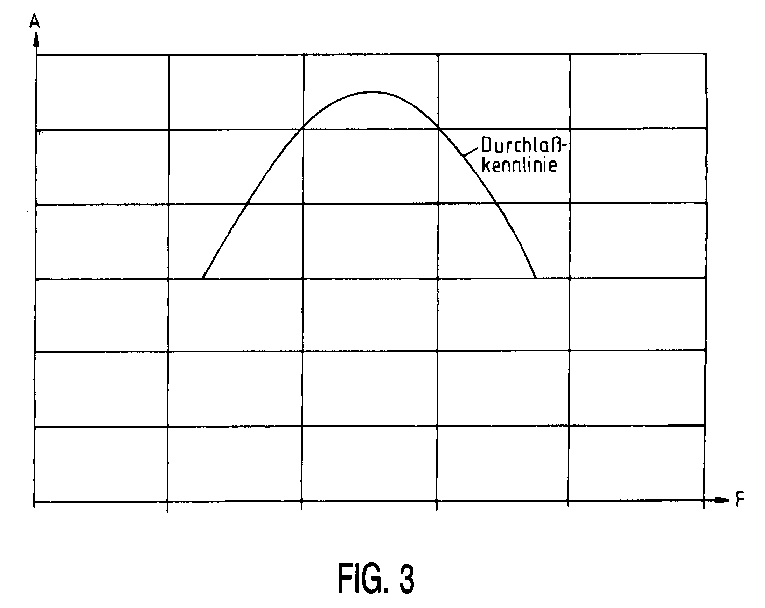

Im integrierten Schaltkreis eines frequenzmodulierten (FM) Radioempfängers wird das Zwischenfrequenzsignal (Frequenz des Zwischenfrequenzsignals ZFS) (vgl. Figur 2) durch ein integriertes Filter mit gewölbter Durchlaßkennlinie (vgl. Figur 3) geschickt, bevor es über die beiden Eingangsanschlüsse 10i1 und 10i2 in die anhand Figur 1 exemplarisch veranschaulichte Schaltungsanordnung 100 gelangt, die aus diesem Signal die Pegelinformation gewinnt und ein in seiner Amplitude A begrenztes Gleichspannungssignal erzeugt und verstärkt, dessen an einer Stromaddierereinheit 80 (vgl. Figur 1) gemessene Pegelspannung im wesentlichen proportional zum Logarithmus der Spannungsamplitude des Signals ist.

Hierzu weist die Schaltungsanordnung 100 eine Verstärkerschaltung mit drei Verstärkungsstufen 10 bzw. 20 bzw. 30 auf. Jede dieser drei Verstärkungsstufen 10 bzw. 20 bzw. 30 wiederum weist zwei npn-Transistoren 12, 14 bzw. 22, 24 bzw. 32, 34 auf, deren jeweilige Emitteranschlüsse 126, 146 bzw. 226, 246 bzw. 326, 346 zusammengeschaltet sind.

Um nun eine Gleichspannung zu erzeugen, die in weiten Bereichen proportional zum Logarithmus der Amplitude der Spannung der über den ersten Eingangsanschluß 10i1 der ersten Verstärkungsstufe 10 sowie über den zweiten Eingangsanschluß 10i2 der ersten Verstärkungsstufe 10 zugeführten Eingangssignale ist, ist innerhalb jeder der Verstärkungsstufen 10 bzw. 20 bzw. 30 mindestens eine Gleichrichterstufe 15 bzw. 25 bzw. 35 vorgesehen; jede dieser Gleichrichterstufen 15 bzw. 25 bzw. 35 wiederum weist zwei npn-Transistoren 16, 18 bzw. 26, 28 bzw. 36, 38 auf, deren jeweilige Emitteranschlüsse 166, 186 bzw. 266, 286 bzw. 366, 386 zusammengeschaltet sind.

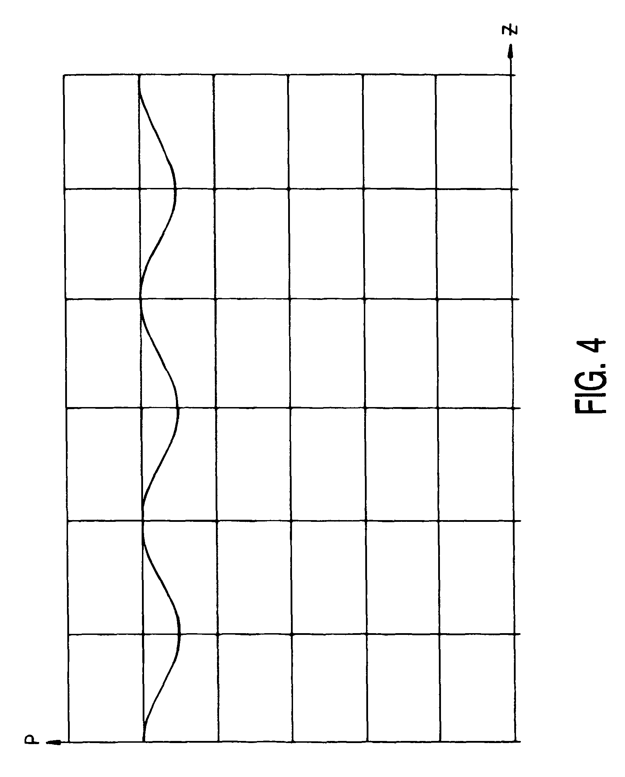

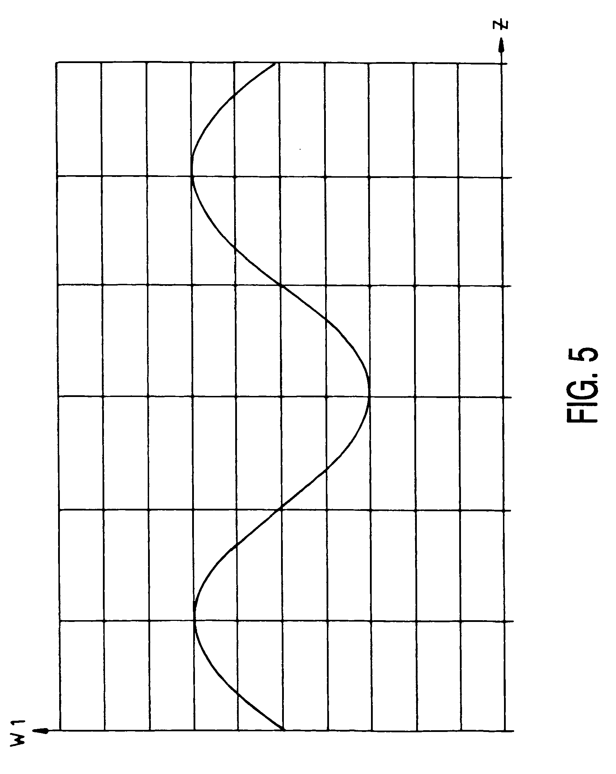

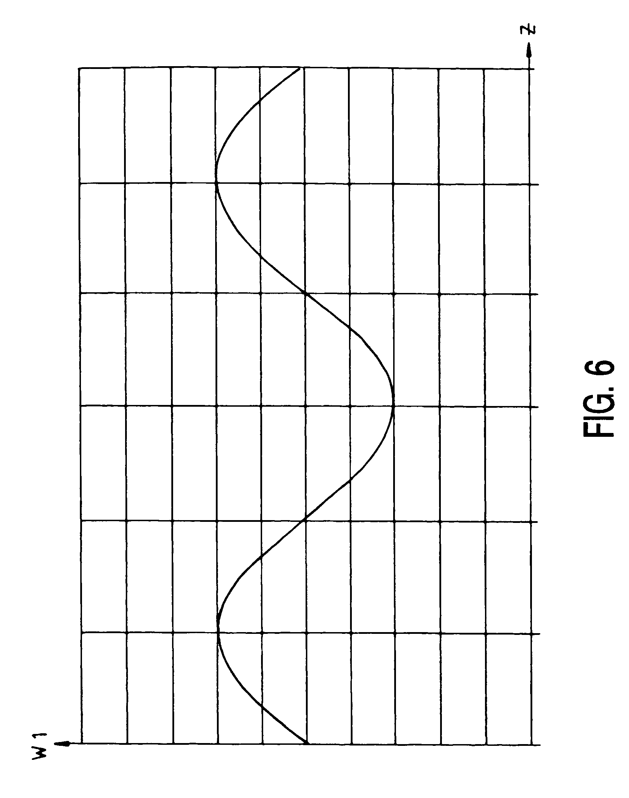

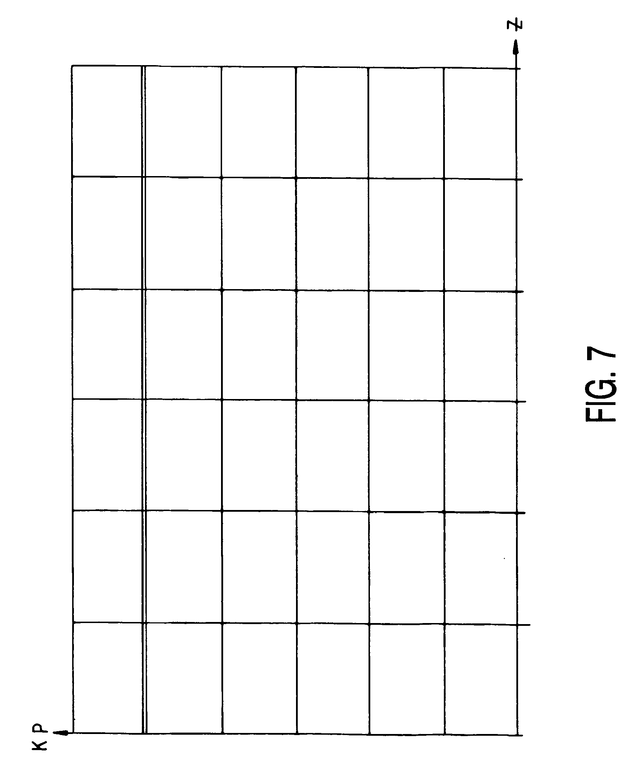

Da nun die in der Verstärkerschaltung gewonnene Pegelinformation von der im integrierten Filter (vgl. Figur 3) entstehenden Pegelschwankung überlagert ist (Pegelspannung mit überlagerter Pegelschwankung P) (vgl. Figur 4), wird zum Kompensieren dieses Fehlers der Wechselspannungsanteil des Ausgangssignals (Wechselspannungsanteil des Ausgangssignals der Freqenz-(FM)Demodulatoreinheit W1) (vgl. Figur 5) der Frequenz-(FM-)Demodulatoreinheit 40 in der als Korrekturschaltung fungierenden Quadriererstufe 50, 60, 70 quadriert (quadrierter Wechselspannungsanteil des Ausgangssignals der Frequenz-(FM)Demodulatoreinheit W2) (vgl. Figur 6) und als Korrektursignal zum Pegelsignal der Verstärkerschaltung addiert (korrigierte Regelspannung KP) (vgl. Figur 7).

Hierzu ist parallel an den Ausgang des Frequenzdemodulators 40, dessen Eingang mit dem Ausgang der letzten Verstärkungsstufe 30 verbunden ist, eine nicht-gegengekoppelte Differenzverstärkerstufe 50 geschaltet; im speziellen ist jeweils ein Ausgangsanschluß 30o1 bzw. 30o2 der letzten Verstärkungsstufe 30 über die Frequenz-(FM-)Demodulatoreinheit 40 mit der jeweiligen Basis 524 bzw. 544 zweier npn-Transistoren 52 bzw. 54 verbunden. Diese Differenzverstärkerstufe 50 ist an eine Stromquelle 56 angeschlossen, wobei die jeweiligen Emitteranschlüsse 526 bzw. 546 der beiden npn-Transistoren 52 bzw. 54 zusammengeschaltet und an die Stromquelle 56 angeschlossen sind.

Wie des weiteren aus Figur 1 hervorgeht, ist der Differenzverstärkerstufe 50 eine Zwischenstufe 60 zugeordnet, indem die Kollektoren 522 bzw. 542 der npn-Transistoren 52 bzw. 54 mit der Zwischenstufe 60 verbunden sind. Die Zwischenstufe 60 weist vier Transistoren 62 bzw. 64 und 66 bzw. 68, nämlich zwei pnp-Transistoren 62, 68 und zwei npn-Transistoren 64, 66, auf, die zumindest partiell an eine Versorgungsspannung Us angeschlossen sind. Des weiteren sind der Zwischenstufe 60 noch zwei pnp-Transistoren 65, 69 zugeordnet.

Der Differenzverstärkerstufe 50 und der Zwischenstufe 60 ist eine Multipliziererstufe 70 zum Multiplizieren der Ausgangssignale der Zwischenstufe 60 (vgl. Übergang von Figur 5 auf Figur 6) nachgeschaltet. Dieses multiplizierte Ausgangssignal - genauer dessen Pegelspannung - wird dann in der Stromaddierereinheit 80 zur jeweiligen Pegelspannung der Verstärkungsstufen 10, 20, 30 addiert.

Im speziellen weist diese Multipliziererstufe 70 vier pnp-Transistoren 72 bzw. 74 und 76 bzw. 78 auf. Hierbei sind der Kollektor 742 des zweiten pnp-Transistors 74 sowie der Kollektor 782 des vierten pnp-Transistors 78 an ein Referenzpotential, nämlich an das Erdpotential angeschlossen, wohingegen der Kollektor 722 des ersten pnp-Transistors 72 sowie der Kollektor 762 des dritten pnp-Transistors 76 mit dem Ausgangsanschluß 700o der Quadriererstufe 50, 60, 70 verbunden sind. Des weiteren sind die Basis 724 des ersten pnp-Transistors 72 sowie die Basis 784 des vierten pnp-Transistors 78 mit dem Emitter 646 des zweiten Transistors 64 der Zwischenstufe 60 verbunden, wohingegen die Basis 744 des zweiten pnp-Transistors 74 sowie die Basis 764 des dritten pnp-Transistors 76 ebenso wie die jeweiligen Emitter 726 bzw. 746 sowie 766 bzw. 786 miteinander verbunden sind.

Durch die anhand Figur 1 exemplarisch veranschaulichte Schaltungsanordnung 100 wird bewirkt, dass die Pegelanzeige, das heißt die Pegelspannung des in der Schaltungsanordnung 100 sowie mittels des Verfahrens erzeugten und verstärkten Gleichspannungssignals nur von der Amplitude, nicht jedoch von der Frequenz des Eingangssignals abhängt.

### BEZUGSZEICHENLISTE

- 100: Schaltungsanordnung
- 10: erste Verstärkungsstufe
- 10i1: erster Eingangsanschluß der ersten Verstärkungsstufe 10
- 10i2: zweiter Eingangsanschluß der ersten Verstärkungsstufe 10
- 12: erster Transistor, insbesondere erster npn-Transistor, der ersten Verstärkungsstufe 10
- 126: Emitter des ersten Transistors 12 der ersten Verstärkungsstufe 10
- 14: zweiter Transistor, insbesondere zweiter npn-Transistor, der ersten Verstärkungsstufe 10
- 146: Emitter des zweiten Transistors 14 der ersten Verstärkungsstufe 10
- 15: erste Gleichrichterstufe
- 16: erster Transistor, insbesondere erster npn-Transistor, der ersten Gleichrichterstufe 15
- 166: Emitter des ersten Transistors 16 der ersten Gleichrichterstufe 15
- 18: zweiter Transistor, insbesondere zweiter npn-Transistor, der ersten Gleichrichterstufe 15
- 186: Emitter des zweiten Transistors 18 der ersten Gleichrichterstufe 15
- 20: zweite Verstärkungsstufe
- 22: erster Transistor, insbesondere erster npn-Transistor, der zweiten Verstärkungsstufe 20
- 226: Emitter des ersten Transistors 22 der zweiten Verstärkungsstufe 20
- 24: zweiter Transistor, insbesondere zweiter npn-Transistor, der zweiten Verstärkungsstufe 20
- 246: Emitter des zweiten Transistors 24 der zweiten Verstärkungsstufe 20
- 25: zweite Gleichrichterstufe
- 26: erster Transistor, insbesondere erster npn-Transistor, der zweiten Gleichrichterstufe 25
- 266: Emitter des ersten Transistors 26 der zweiten Gleichrichterstufe 25
- 28: zweiter Transistor, insbesondere zweiter npn-Transistor, der zweiten Gleichrichterstufe 25
- 286: Emitter des zweiten Transistors 28 der zweiten Gleichrichterstufe 25
- 30: dritte Verstärkungsstufe = letzte Verstärkungsstufe
- 30o1: erster Ausgangsanschluß der letzten Verstärkungsstufe 30
- 30o2: zweiter Ausgangsanschluß der letzten Verstärkungsstufe 30
- 300o: Ausgangsanschluß der Verstärkerschaltung
- 32: erster Transistor, insbesondere erster npn-Transistor, der letzten Verstärkungsstufe 30
- 326: Emitter des ersten Transistors 32 der letzten Verstärkungsstufe 30
- 34: zweiter Transistor, insbesondere zweiter npn-Transistor, der letzten Verstärkungsstufe 30
- 346: Emitter des zweiten Transistors 34 der letzten Verstärkungsstufe 30
- 35: dritte Gleichrichterstufe = letzte Gleichrichterstufe
- 36: erster Transistor, insbesondere erster npn-Transistor, der letzten Gleichrichterstufe 35
- 366: Emitter des ersten Transistors 36 der letzten Gleichrichterstufe 35
- 38: zweiter Transistor, insbesondere zweiter npn-Transistor, der letzten Gleichrichterstufe 35
- 386: Emitter des zweiten Transistors 38 der letzten Gleichrichterstufe 35
- 40: Frequenz-(FM-)Demodulatoreinheit
- 50: Differenzverstärkerstufe
- 50i1: erster Eingangsanschluß der Differenzverstärkerstufe 50
- 50i2: zweiter Eingangsanschluß der Differenzverstärkerstufe 50
- 52: erster Transistor, insbesondere erster npn-Transistor, der Differenzverstärkerstufe 50
- 522: Kollektor des ersten Transistors 52 der Differenzverstärkerstufe 50
- 524: Basis des ersten Transistors 52 der Differenzverstärkerstufe 50
- 526: Emitter des ersten Transistors 52 der Differenzverstärkerstufe 50
- 54: zweiter Transistor, insbesondere zweiter npn-Transistor, der Differenzverstärkerstufe 50
- 542: Kollektor des zweiten Transistors 54 der Differenzverstärkerstufe 50
- 544: Basis des zweiten Transistors 54 der Differenzverstärkerstufe 50
- 546: Emitter des zweiten Transistors 54 der Differenzverstärkerstufe 50
- 56: Stromquelle
- 60: Zwischenstufe
- 62: erster Transistor, insbesondere erster pnp-Transistor, der Zwischenstufe 60
- 622: Kollektor des ersten Transistors 62 der Zwischenstufe 60
- 624: Basis des ersten Transistors 62 der Zwischenstufe 60
- 626: Emitter des ersten Transistors 62 der Zwischenstufe 60
- 64: zweiter Transistor, insbesondere erster npn-Transistor, der Zwischenstufe 60
- 642: Kollektor des zweiten Transistors 64 der Zwischenstufe 60
- 644: Basis des zweiten Transistos 64 der Zwischenstufe 60
- 646: Emitter des zweiten Transistors 64 der Zwischenstufe 60
- 65: erster der Zwischenstufe 60 zugeordneter Transistor, insbesondere pnp-Transistor
- 652: Kollektor des ersten zugeordneten Transistors 65
- 654: Basis des ersten zugeordneten Transistors 65
- 656: Emitter des ersten zugeordneten Transistors 65
- 66: dritter Transistor, insbesondere zweiter npn-Transistor, der Zwischenstufe 60
- 662: Kollektor des dritten Transistors 66 der Zwischenstufe 60
- 664: Basis des dritten Transistors 66 der Zwischenstufe 60
- 666: Emitter des dritten Transistors 66 der Zwischenstufe 60
- 68: vierter Transistor, insbesondere zweiter pnp-Transistor, der Zwischenstufe 60
- 682: Kollektor des vierten Transistors 68 der Zwischenstufe 60
- 684: Basis des vierten Transistors 68 der Zwischenstufe 60
- 686: Emitter des vierten Transistors 68 der Zwischenstufe 60
- 69: zweiter der Zwischenstufe 60 zugeordneter Transistor, insbesondere pnp-Transistor
- 692: Kollektor des zweiten zugeordneten Transistors 69
- 694: Basis des zweiten zugeordneten Transistors 69
- 696: Emitter des zweiten zugeordneten Transistors 69
- 70: Multipliziererstufe
- 700o: Ausgangsanschluß der Multipliziererstufe 70
- 72: erster Transistor, insbesondere erster pnp-Transistor, der Multipliziererstufe 70
- 722: Kollektor des ersten Transistors 72 der Multipliziererstufe 70
- 724: Basis des ersten Transistors 72 der Multipliziererstufe 70
- 726: Emitter des ersten Transistors 72 der Multipliziererstufe 70
- 74: zweiter Transistor, insbesondere zweiter pnp-Transistor, der Multipliziererstufe 70
- 742: Kollektor des zweiten Transistors 74 der Multipliziererstufe 70
- 744: Basis des zweiten Transistors 74 der Multipliziererstufe 70
- 746: Emitter des zweiten Transistors 74 der Multipliziererstufe 70
- 76: dritter Transistor, insbesondere dritter pnp-Transistor, der Multipliziererstufe 70
- 762: Kollektor des dritten Transistors 76 der Multipliziererstufe 70
- 764: Basis des dritten Transistors 76 der Multipliziererstufe 70
- 766: Emitter des dritten Transistors 76 der Multipliziererstufe 70
- 78: vierter Transistor, insbesondere vierter pnp-Transistor, der Multipliziererstufe 70
- 782: Kollektor des vierten Transistors 78 der Multipliziererstufe 70
- 784: Basis des vierten Transistors 78 der Multipliziererstufe 70
- 786: Emitter des vierten Transistors 78 der Multipliziererstufe 70
- 80: Stromaddierereinheit
- Us: Versorgungsspannung

## Patentansprüche

1. Schaltungsanordnung (100) zum Erzeugen und Verstärken eines in seiner Amplitude begrenzten Gleichspannungssignals, dessen Pegelspannung Im wesentlichen proportional zum Logarithmus der Spannungsamplitude eines frequenzmodulierten Zwischenfrequenzsignal (ZFS) ist, aufweisend
- eine Verstärkerschaltung mit mindestens zwei Verstärkungsstufen (10; 20; 30), wobei jede Verstärkungsstufe (10; 20; 30) mindestens eine Gleichrichterstufe (15, 25, 35) aufweist, wobei der Verstärkungsschaltung das durch ein integriertes Zwischenfrequenzfilter mit gewölbter Durchlasskennlinie geführte Zwischenfrequenzslgnal (ZFS) zugeführt wird, und wobei die Verstärkerschaltung die Pegelspannung des durch das integrierte Filter geführten Zwischenfrequenzsignals erfasst,
- eine Frequenz-(FM)-Demodulatoreinheit (40), die der letzten Verstärkerstufe (30) der Verstärkungsschaltung nachgeschaltet ist, und zum Demodulieren des Ausgangssignals der letzten Verstärkerstufe (30) dient,
- mindestens eine Quadriererstufe (50, 60, 70) zum Quadrieren des Ausgangssignals der Frequenz-(FM)-Demodulatoreinheit (40), insbesondere des Wechselspannungsanteils des Ausgangssignals der Frequenz-(FM-) Demodulatoreinheit (40), und
- mindestens eine Stromaddierereinheit (80) zum Addieren der Pegelspannung des quadrierten Wechselspannungsanteils aus der Quadriererstufe (50, 60, 70) zu der von der Verstärkerschaltung erfassten Pegelspannung, wobei das erzeugte und verstärkte Gleichspannungssignal nur von der Amplitude nicht jedoch von der Frequenz des Zwischenfrequenzsignals abhängt.

2. Schaltungsanordnung (100) gemäss Anspruch 1,
**dadurch gekennzeichnet,**
**dass** unter Bildung der Quadriererstufe (50, 60, 70)
- mindestens eine gegengekoppelte oder nicht-gegengekoppelte Differenzverstärkerstufe (50) an den Ausgang eines Frequenzdemodulators (40) geschaltet ist,
- **dass** der Differenzvestärkerstufe (50) mindestens eine Zwischenstufe (60) zugeordnet ist und
- **dass** der Differenzverstärkerstufe (50) und der Zwischenstufe (60) mindestens eine Multipliziererstufe (70) zum Multiplizieren des Ausgangssignals der Zwischenstufe (60) nachgeschaltet ist.

3. Schaltungsanordnung (100) gemäss Anspruch 2,
**dadurch gekennzeichnet,**
**dass** die Zwischenstufe (60) mindestens eine Stromspegeleinheit aufweist.

4. Schaltungsanordnung (100) gemäss Anspruch 2 oder 3,
**dadurch gekennzeichnet,**
**dass** die Differenzverstärkerstufe (50) an mindestens eine Stromquelle (56) angeschlossen ist.

5. Schaltungsanordnung (100) gemäss Anspruch 4,
**dadurch gekennzeichnet,**
**dass** die Kennlinie der Pegelspannung der Schaltungsanordnung (100)
- durch Erhöhen der von der Stromquelle (56) zur Verfügung gestellten Stromstärke und/oder
- durch Zwischenschalten hochohmiger Widerstände
zu kleineren Pegelspannungen der Schaltungsanordnung (100) hin verlängerbar ist.

6. Schaltungsanordnung (100) gemäss mindestens einem der Ansprüche 2 bis 5,
**dadurch gekennzeichnet,**
**dass** die Differenzverstärkerstufe (50) mindestens zwei Transistoren (52, 54), insbesondere npn-Transistoren, aufweist.

7. Schaltungsanordnung (100) gemäss Anspruch 6,
**dadurch gekennzeichnet,**
**dass** die Emitter (526, 546) der Transistoren (52, 54) miteinander verbunden sind und an die Stromquelle (56) angeschlossen sind.

8. Schaltungsanordnung (100) gemäss Anspruch 6 oder 7,
**dadurch gekennzeichnet,**
**dass** jeweils ein Ausgangsanschluss (30o1 bzw. 30o2) der letzten Verstärkungsstufe (30) über die Frequenz-(FM-)Demodulatoreinheit (40) mit der jeweiligen Basis (524 bzw. 544) der Transistoren (52 bzw. 54) verbunden ist.

9. Schaltungsanordnung (100) gemäss mindestens einem der Ansprüche 6 bis 8,
**dadurch gekennzeichnet,**
**dass** die Kollektoren (522 bzw. 542) der Transistoren (52 bzw. 54) mit der Zwischenstufe (60) verbunden sind.

10. Schaltungsanordnung (100) gemäss mindestens einem der Ansprüche 2 bis 9,
**dadurch gekennzeichnet,**
**dass** die Zwischenstufe (60) mindestens vier Transistoren (62 bzw. 64, 66 bzw. 68), insbesondere mindestens zwei pnp-Transistoren (62, 68) und mindestens zwei npn-Transistoren (64, 66), aufweist, die zumindest partiell an eine Versorgungsspannung (Us) angeschlossen sind.

11. Schaltungsanordnung (100) gemäss mindestens einem der Ansprüche 2 bis 10,
**dadurch gekennzeichnet,**
**dass** der Zwischenstufe (60) mindestens zwei Transistoren (65, 69), insbesondere mindestens zwei pnp-Transistoren, zugeordnet sind.

12. Schaltungsanordnung (100) gemäss mindestens einem der Ansprüche 2 bis 11,
**dadurch gekennzeichnet,**
**dass** die Multipliziererstufe (70) mindestens vier Transistoren (72 bzw. 74, 76 bzw. 78), insbesondere pnp-Transistoren, aufweist,
- deren jeweiliger Kollektor (742, 782) an ein Referenzpotential angeschlossen ist bzw. deren jeweiliger Kollektor (722, 762) mit dem Ausgangsanschluss (700o) der Quadriererstufe (50, 60, 70) verbunden ist,
- deren jeweilige Basis (724, 784) mit dem Emitter (646) des zweiten Transistors (64) der Zwischenstufe (60) verbunden ist bzw. deren jeweilige Basen (744, 764) miteinander verbunden sind und
- deren jeweilige Emitter (726 bzw. 746, 766 bzw. 786) miteinander verbunden sind.

13. Schaltungsanordnung (100) gemäss Anspruch 12,
**dadurch gekennzeichnet,**
**dass** das Referenzpotential das Erdpotential und/oder das Massepotential ist.

14. Schaltungsanordnung (100) gemäss mindestens einem der Ansprüche 1 bis 13,
**dadurch gekennzeichnet,**
**dass** jede der Verstärkungsstufen (10; 20; 30) mindestens zwei Transistoren (12, 14; 22, 24; 32, 34), insbesondere mindestens zwei npn-Transistoren, aufweist, deren jewellige Emitter (126, 146; 226, 246; 326, 346) miteinander verbunden sind.

15. Schaltungsanordnung (100) gemäss Anspruch 14,
**dadurch gekennzeichnet,**
**dass** jede der Gleichrichterstufen (15; 25; 35) mindestens zwei Transistoren (16, 18; 26, 28; 36, 38), insbesondere mindestens zwei npn-Transistoren, aufweist, deren jeweilige Emitter (166, 186; 266, 286; 366, 386) miteinander verbunden sind.

16. Integrierte Schaltung insbesondere analoge integrierte Schaltung, aufweisend mindestens eine Schaltungsanordnung (100) gemäss mindestens einem der Ansprüche 1 bis 15.

17. Verfahren zum Erzeugen und Verstärken eines in seiner Amplitude begrenzten Gleichspannungssignals, dessen Pegelspannung im Wesentlichen proportional zum Logarithmus der Spannungsamplitude eines Zwischenfrequenzsignals (ZFS) ist, die folgenden Schritte aufweisend:
- Anlegen des durch ein integriertes Zwischenfrequenzfilter mit gewölbter Durchlasskennlinie geführten frequenzmodulierten Zwischenfrequenzsignals (ZFS) an eine Verstärkerschaltung;
- Anzeigen und/oder Erfassen einer Pegelspannung des durch das integrierte Filter geführten Zwischenfrequenzsignals durch die Verstärkerschaltung, wobei die Verstärkerschaltung mindestens zwei Verstärkungsstufen (10; 20; 30) mit jeweils mindestens einer Gleichrichterstufe (15, 25, 35) aufweist,;
- Demodulieren des Ausgangssignals der letzten Verstärkungsstufe (30) der Verstärkerschaltung, insbesondere der Kollektorschaltungen der letzten Verstärkungsstufe (30), mittels mindestens einer Frequenz-(FM)-Demodulatoreinheit (40);
- Quadrieren des Ausgangssignals der Frequenz-(FM)-Demodulatoreinheit (40), insbesondere des Wechselspannungsanteils des Ausgangssignals der Frequenz-(FM-) Demodulatoreinheit (40), mit mindestens einer Quadriererstufe (50, 60, 70); und
- Addieren der Pegelspannung des quadrierten Wechselspannungsanteils aus der Quadriererstufe (50, 60, 70) zu der von der Verstärkerschaltung erfassten Pegelspannung mit mindestens einer Stromaddierereinheit (80), wobei das erzeugte und verstärkte Gleichspannungssignal nur von der Amplitude nicht jedoch von der Frequenz des Zwischenfrequenzsignals abhängt.

## Claims

1. A circuit arrangement (100) for generating and amplifying an amplitude-limited dc voltage signal, the level voltage of which is substantially proportional to the logarithm of the voltage amplitude of a frequency-modulated intermediate frequency signal (ZFS), comprising
- an amplifier circuit having at least two amplifier stages (10; 20; 30), wherein each amplifier stage (10; 20; 30) has at least one rectifier stage (15, 25, 35, wherein the intermediate frequency signal (ZFS) which is passed through an integrated intermediate frequency filter with a curved transmission characteristic is fed to the amplifier circuit and wherein the amplifier circuit detects the level voltage of the intermediate frequency signal which is passed through the integrated filter,
- a frequency (FM) demodulator unit (40) which is connected downstream of the last amplifier stage (30) of the amplifier circuit and serves for demodulation of the output signal of the last amplifier stage (30),
- at least one squaring stage (50, 60, 70) for squaring the output signal of the frequency (FM) demodulator unit (40), in particular the ac voltage component of the output signal of the frequency (FM) demodulator unit (40), and
- at least one current adding unit (80) for adding the level voltage of the squared ac voltage component from the squaring stage (50, 60, 70) to the level voltage detected by the amplifier circuit, wherein the generated and amplified dc voltage signal depends only on the amplitude but not the frequency of the intermediate frequency signal.

2. A circuit arrangement (100) according to claim 1 **characterised in that** with the formation of the squaring stage (50, 60, 70)
- at least one differential amplifier stage (50) with negative feedback or no negative feedback is connected to the output of a frequency demodulator (40),
- at least one intermediate stage (60) is associated with the differential amplifier stage (50), and
- at least one multiplier stage (70) for multiplying the output signal of the intermediate stage (60) is connected downstream of the differential amplifier stage (50) and the intermediate stage (60).

3. A circuit arrangement (100) according to claim 2 **characterised in that** the intermediate stage (60) comprises at least one current mirror unit.

4. A circuit arrangement (100) according to claim 2 or claim 3 **characterised in that** the differential amplifier stage (50) is connected to at least one current source (56).

5. A circuit arrangement (100) according to claim 4 **characterised in that** the characteristic curve of the level voltage of the circuit arrangement (100) can be extended to lower level voltages of the circuit arrangement (100)
- by increasing the current strength made available by the current source (56) and/or
- by the intercalation of high-ohmic resistors.

6. A circuit arrangement (100) according to at least one of claims 2 to 5 **characterised in that** the differential amplifier stage (50) has at least two transistors (52, 54), in particular npn-transistors.

7. A circuit arrangement (100) according to claim 6 **characterised in that** the emitters (526, 546) of the transistors (52, 54) are connected together and are connected to the current source (56).

8. A circuit arrangement (100) according to claim 6 or claim 7 **characterised in that** a respective output terminal (30o1 and 30o2) of the last amplifier stage (30) is connected by way of the frequency (FM) demodulator unit (40) to the respective base (524 and 544) of the transistors (52 and 54 respectively).

9. A circuit arrangement (100) according to at least one of claims 6 to 8 **characterised in that** the collectors (522 and 542) of the transistors (52 and 54 respectively) are connected to the intermediate stage (60).

10. A circuit arrangement (100) according to at least one of claims 2 to 9 **characterised in that** the intermediate stage (60) comprises at least four transistors (62 and 64 respectively, 66 and 68 respectively), in particular at least two pnp-transistors (62, 68) and at least two npn-transistors (64, 66) which are at least partially connected to a supply voltage (Us).

11. A circuit arrangement (100) according to at least one of claims 2 to 10 **characterised in that** at least two transistors (65, 69), in particular at least two pnp-transistors, are associated with the intermediate stage (60).

12. A circuit arrangement (100) according to at least one of claims 2 to 11 **characterised in that** the multiplier stage has at least four transistors (72 and 74 respectively, 76 and 78 respectively), in particular pnp-transistors,
- whose respective collector (742, 782) is connected to a reference potential and whose respective collector (722, 762) is connected to the output terminal (700o) of the squaring stage (50, 60, 70),
- whose respective base (724, 784) is connected to the emitter (646) of the second transistor (64) of the intermediate stage (60) and whose respective bases (744, 764) are connected together, and
- whose respective emitters (726 and 746 respectively, 766 and 786 respectively) are connected together.

13. A circuit arrangement (100) according to claim 12 **characterised in that** the reference potential is the earth potential and/or the ground potential.

14. A circuit arrangement (100) according to at least one of claims 1 to 13 **characterised in that** each of the amplifier stages (10; 20; 30) has at least two transistors (12, 14; 22, 24; 32, 34), in particular at least two npn-transistors whose respective emitters (126, 146; 226, 246; 326, 346) are connected together.

15. A circuit arrangement (100) according to claim 14 **characterised in that** each of the rectifier stages (15; 25; 35) has at least two transistors (16, 18; 26, 28; 36, 38), in particular at least two npn-transistors whose respective emitters (166, 186; 266, 286; 366, 386) are connected together.

16. An integrated circuit, in particular an analog integrated circuit, comprising at least one circuit arrangement (100) according to at least one of claims 1 to 15.

17. A method of generating and amplifying an amplitude-limited dc voltage signal whose level voltage is substantially proportional to the logarithm of the voltage amplitude of an intermediate frequency signal (ZFS), which comprises the following steps:
- applying the frequency-modulated intermediate frequency signal (ZFS) which is passed through an integrated intermediate frequency filter with a curved transmission characteristic to an amplifier circuit;
- displaying and/or detecting a level voltage of the intermediate frequency signal passed through the integrated filter by the amplifier circuit, wherein the amplifier circuit has at least two amplifier stages (10; 20; 30) each having at least one respective rectifier stage (15, 25, 35);
- demodulating the output signal of the last amplifier stage (30) of the amplifier circuit, in particular the collector circuits of the last amplifier stage (30), by means of at least one frequency (FM) demodulator unit (40);
- squaring the output signal of the frequency (FM) demodulator unit (40), in particular the ac voltage component of the output signal of the frequency (FM) demodulator unit (40) with at least one squaring stage (50, 60, 70); and
- adding the level voltage of the squared ac voltage component from the squaring stage (50, 60, 70) to the level voltage detected by the amplifier circuit with at least one current adding unit (80), wherein the generated and amplified dc voltage signal is dependent only on the amplitude but not the frequency of the intermediate frequency signal.

## Revendications

1. Circuit électrique (100) pour générer et amplifier un signal à tension continue d'amplitude limitée, dont la tension indicative est essentiellement proportionnelle au logarithme de l'amplitude de tension d'un signal à fréquence intermédiaire (SFI) modulé en fréquence, comprenant :
- un circuit amplificateur avec au moins deux étages amplificateurs (10 ; 20 ; 30), chaque étage amplificateur (10 ; 20 ; 30) présentant au moins un étage redresseur (15, 25, 35), le signal à fréquence intermédiaire (SFI) étant acheminé au circuit amplificateur à travers un filtre à fréquence intermédiaire intégré avec une caractéristique de transfert en courbe, et le circuit amplificateur détectant la tension indicative du signal à fréquence intermédiaire acheminé à travers le filtre intégré,
- un dispositif de démodulation (FM) de fréquence (40) monté en aval du dernier étage amplificateur (30) du circuit amplificateur, et servant à démoduler le signal de sortie du dernier étage amplificateur (30),
- au moins un étage conformateur d'impulsions carrées (50, 60, 70) pour la conformation en impulsions carrées du signal de sortie du dispositif de démodulation (FM) de fréquence (40), en particulier de la composante de tension alternative du signal de sortie du dispositif de démodulation (FM) de fréquence (40), et
- au moins une unité d'addition de courant (80) pour additionner la tension indicative de la composante de tension alternative à conformation d'impulsions carrées provenant de l'étage conformateur d'impulsions carrées (50, 60, 70) à la tension indicative détectée par le circuit amplificateur, le signal de tension continue généré et amplifié dépendant seulement de l'amplitude, et non pas de la fréquence du signal à fréquence intermédiaire.

2. Circuit électrique (100) selon la revendication 1,
**caractérisé en ce**
**que**, lors de la formation de l'étage conformateur d'impulsions carrées (50, 60, 70),
- au moins un étage de gain en mode différentiel (50) contrecouplé ou non contrecouplé est connecté à la sortie d'un démodulateur de fréquence (40),
- au moins un étage intermédiaire (60) est associé à l'étage de gain en mode différentiel (50), et
- au moins un étage multiplicateur (70) pour multiplier le signal de sortie de l'étage intermédiaire (60) est monté en aval de l'étage de gain en mode différentiel (50) et de l'étage intermédiaire (60).

3. Circuit électrique (100) selon la revendication 2,
**caractérisé en ce**
**que** l'étage intermédiaire (60) comprend au moins une unité indicatrice de niveau d'intensité du courant.

4. Circuit électrique (100) selon la revendication 2 ou 3,
**caractérisé en ce**
**que** l'étage de gain en mode différentiel (50) est raccordé à au moins une source de courant (56).

5. Circuit électrique (100) selon la revendication 4,
**caractérisé en ce**
**que** la caractéristique de la tension indicative du circuit électrique (100) peut être allongée
- en augmentant l'intensité du courant mis à disposition par la source de courant (56) et/ou
- en connectant de manière intermédiaire des résistances à haute impédance, pour des niveaux plus bas de la tension indicative du circuit électrique (100).

6. Circuit électrique (100) selon l'une quelconque au moins des revendications 2 à 5,
**caractérisé en ce**
**que** l'étage de gain en mode différentiel (50) présente au moins deux transistors (52, 54), en particulier des transistors npn.

7. Circuit électrique (100) selon la revendication 6,
**caractérisé en ce**
**que** les émetteurs (526, 546) des transistors (52, 54) sont reliés entre eux et raccordés à la source de courant (56).

8. Circuit électrique (100) selon la revendication 6 ou 7,
**caractérisé en ce**
**que** respectivement une borne de sortie (30o1 ou 30o2) du dernier étage amplificateur (30) est en liaison, via le dispositif de démodulation (FM) de fréquence (40), avec la base respective (524 ou 544) des transistors (52 ou 54).

9. Circuit électrique (100) selon l'une quelconque au moins des revendications 6 à 8,
**caractérisé en ce**
**que** les collecteurs (522 ou 542) des transistors (52 ou 54) sont en liaison avec l'étage intermédiaire (60).

10. Circuit électrique (100) selon l'une quelconque au moins des revendications 2 à 9,
**caractérisé en ce**
**que** l'étage intermédiaire (60) présente au moins quatre transistors (62 ou 64, 66 ou 68), en particulier au moins deux transistors pnp (62, 68) et au moins deux transistors npn (64, 66), lesquels sont au moins partiellement raccordés à une tension d'alimentation (Us).

11. Circuit électrique (100) selon l'une quelconque au moins des revendications 2 à 10,
**caractérisé en ce**
**que** l'on associe à l'étage intermédiaire (60) au moins deux transistors (65, 69), en particulier au moins deux transistors pnp.

12. Circuit électrique (100) selon l'une quelconque au moins des revendications 2 à 11,
**caractérisé en ce**
**que** l'étage multiplicateur (70) comprend au moins quatre transistors (72 ou 74, 76 ou 78), en particulier des transistors pnp,
- dont le collecteur respectif (742, 782) est raccordé à un potentiel de référence ou dont le collecteur respectif (722, 762) est en liaison avec la borne de sortie (700o) de l'étage conformateur d'impulsions carrées (50, 60, 70),
- dont la base respective (724, 784) est en liaison avec l'émetteur (646) du deuxième transistor (64) de l'étage intermédiaire (60) ou dont les bases respectives (744, 764) sont reliées entre elles, et
- dont les émetteurs respectifs (726 ou 746, 766 ou 786) sont reliés entre eux.

13. Circuit électrique (100) selon la revendication 12,
**caractérisé en ce**
**que** le potentiel de référence est le potentiel de terre et/ou le potentiel de masse.

14. Circuit électrique (100) selon l'une quelconque au moins des revendications 1 à 13,
**caractérisé en ce**
**que** chacun des étages amplificateurs (10 ; 20 ; 30) présente au moins deux transistors (12, 14 ; 22, 24 ; 32, 34), en particulier au moins deux transistors npn, dont les émetteurs respectifs (126, 146 ; 226, 246 ; 326, 346) sont reliés entre eux.

15. Circuit électrique (100) selon la revendication 14,
**caractérisé en ce**
**que** chacun des étages redresseurs (15 ; 25 ; 35) présente au moins deux transistors (16, 18 ; 26, 28 ; 36, 38), en particulier au moins deux transistors npn, dont les émetteurs respectifs (166, 186 ; 266, 286 ; 366, 386) sont reliés entre eux.

16. Circuit intégré, en particulier circuit intégré analogique, présentant au moins un circuit électrique (100) selon l'une quelconque au moins des revendications 1 à 15.

17. Procédé pour générer et amplifier un signal de tension continue à amplitude limitée, dont la tension indicative est essentiellement proportionnelle au logarithme de l'amplitude de tension d'un signal à fréquence intermédiaire (SFI), présentant les étapes suivantes :
- envoi du signal à fréquence intermédiaire (SFI) modulé en fréquence, acheminé à travers un filtre à fréquence intermédiaire intégré avec une caractéristique de transfert en courbe vers un circuit amplificateur ;
- indication et/ou détection d'une tension indicative du signal à fréquence intermédiaire acheminé à travers le filtre intégré au circuit amplificateur, le circuit amplificateur comprenant au moins deux étages amplificateurs (10 ; 20 ; 30) avec respectivement au moins un étage redresseur (15, 25, 35) ;
- démodulation du signal de sortie du dernier étage amplificateur (30) du circuit amplificateur, en particulier des circuits collecteurs du dernier étage amplificateur (30), à l'aide d'au moins un dispositif de démodulation (FM) de fréquence (40);
- conformation en impulsions carrées du signal de sortie du dispositif de démodulation (FM) de fréquence (40), en particulier de la composante de tension alternative du signal de sortie du dispositif de démodulation (FM) de fréquence (40), avec au moins un étage conformateur d'impulsions carrées (50, 60, 70) ; et
- addition de la tension indicative de la composante de tension alternative à conformation d'impulsions carrées provenant de l'étage conformateur d'impulsions carrées (50, 60, 70) à la tension indicative détectée par le circuit amplificateur avec au moins une unité d'addition de courant (80), le signal de tension continue généré et amplifié dépendant seulement de l'amplitude, et non pas de la fréquence du signal à fréquence intermédiaire.
